**Europäisches Patentamt**

**European Patent Office**

**Office européen des brevets**

(19)

(11) Veröffentlichungsnummer: **0 175 058**
A2

## (12) EUROPÄISCHE PATENTANMELDUNG

(21) Anmeldenummer: 85106770.2

(22) Anmeldetag: 01.06.85

(51) Int. Cl.⁴: **H 03 G 3/20**

(30) Priorität: **22.08.84 DE 3430807**

(43) Veröffentlichungstag der Anmeldung: **26.03.86**
**Patentblatt 86/13**

(84) Benannte Vertragsstaaten: **AT BE DE FR GB IT LU NL**

(71) Anmelder: **Blaupunkt-Werke GmbH,**
**Robert-Bosch-Strasse 200, D-3200 Hildesheim (DE)**

(72) Erfinder: **Engel, Gerhard, Dipl.-Ing.,**
**Ernst-Abbé-Strasse 45, D-3200 Hildesheim (DE)**
Erfinder: **Ohler, Michael, Dipl.-Ing., In der Dehne 4,**
**D-3211 Despetal (DE)**

(74) Vertreter: **Eilers, Norbert, Dipl.-Phys., Blaupunkt-Werke**
**GmbH Robert-Bosch-Strasse 200, D-3200 Hildesheim**
**(DE)**

(54) **Verfahren und Schaltung zur Erzeugung einer Regelgleichspannung.**

(57) Bei einer Empfangsschaltung für Satellitenfernsehprogramme mit FM-Signalen und mit einer PLL-Demodulation ist es erforderlich, die dem Demodulator zugeführten FM-Signale auf einen konstanten Pegel einzustellen und zu halten. Zu diesem Zweck wird eine von dem Pegel des FM-Signals abhängige Regelgleichspannung erzeugt und mit einer Sollspannung verglichen. Die Differenz beeinflußt als Steuerspannung ein Stellglied zur automatischen Einstellung eines konstanten Pegels des FM-Signals.

Bei der Erfindung wird das FM-Signal mit einem niederfrequenten Hilfssignal moduliert. Durch anschließende Demodulation und Gleichrichtung des demodulierten Signales wird dann die gewünschte Regelgleichspannung gewonnen.

ACTORUM AG

- 1 -

Verfahren und Schaltung zur Erzeugung

einer Regelgleichspannung

Die Erfindung betrifft ein Verfahren zur Erzeugung einer vom Pegel eines hochfrequenten FM-Signals abhängigen Regelgleichspannung für eine automatische Verstärkungsregelschaltung in einer Empfangsschaltung für Satellitenempfänger, insbesondere für Empfänger mit PLL-Demodulation beim Satellitenfernsehen, wobei ein Stellglied durch eine Steuerspannung beeinflußt wird, welche durch Vergleich einer Sollspannung mit der Regelgleichspannung gewonnen wird. Außerdem befaßt sich die Erfindung mit einer Schaltungsanordnung zur Durchführung des Verfahrens.

In neuerer Zeit bedient man sich bei der Übertragung von Programmen, insbesondere von Fernsehprogrammen, immer mehr der Satelliten, um größere Reichweiten zu erzielen und um größere Gebiete versorgen zu können. Vor allem der Empfang von Fernsehprogrammen gewinnt beim sogenannten Satellitenfernsehen eine zunehmende Bedeutung.

So können beispielsweise auch die Fernsehprogramme aus benachbarten Ländern empfangen werden.

Üblich ist die Anwendung der Frequenzmodulation, und empfängerseitig arbeitet man mit einer PLL-Demodulation, die wegen des günstigen Rauschverhaltens bei den in
Frage kommenden relativ schwachen Empfangssignalen
von Vorteil ist.

Ein wichtiger Aspekt bei der PLL-Demodulation ist bekanntlich die Forderung, den Pegel des dem Demodulator
zugeführten FM-Signals auf einen möglichst konstanten
Wert auszuregeln und zu halten, damit dem Wunsch entsprochen werden kann, im linearen Bereich des PLL-Demodulators zu arbeiten.

In der Rundfunktechnik werden zu diesem Zweck bekanntlich Begrenzerschaltungen verwendet, um die FM-Signale
auf einen vorgegebenen Pegelwert zu begrenzen und damit
den Pegel weitgehend konstant zu halten. Es hat sich
allerdings gezeigt, daß sich diese bekannte Technik beim
Satellitenfernsehen mit den extrem hohen Frequenzen im
GHz-Bereich und mit den relativ schwachen Empfangssignalen nicht ohne weiteres anwenden läßt, und daß man
hier auf aufwendigere Schaltungen angewiesen ist.

Um den Pegel eines FM-Signals beim Satellitenfernsehen
automatisch einstellen und halten zu können, wird das
auf eine Zwischenfrequenz umgesetzte FM-Signal nach einer Verstärkung einem Gleichrichter zugeführt, um nach einer weiteren Verstärkung eine Regelgleichspannung
zu erzeugen, deren Wert von dem Pegel des FM-Signals
abhängt. Diese Regelgleichspannung gelangt zu einem
Komparator, welcher durch Vergleich der Regelgleichspannung mit einer Sollspannung eine Steuerspannung
erzeugt. Schließlich wird die Steuerspannung zu einem
als Verstärker mit veränderbarer Verstärkung ausgebildetem Stellglied geführt, um den Pegel des FM-Signals automatisch auf den gewünschten Wert einzustellen.

Es handelt sich bei dieser Technik also um eine typische
Regelschaltung, wobei die Erzeugung der vom Pegel des
FM-Signals abhängigen Regelgleichspannung im Vordergrund steht. Solange die Regelgleichspannung mit dem
vorgegebenen Sollwert übereinstimmt, erfolgt durch das
Stellglied keine Veränderung der Verstärkung, während
bei einer Abweichung die Verstärkung so nachgeregelt
wird, daß sich der gewünschte Pegel wieder einstellt.

In der Praxis hat sich nun gezeigt, daß die Erzeugung
der benötigten Regelgleichspannung mit einem erheblichen
Schaltungsaufwand und somit auch mit beträchtlichen
Kosten verbunden ist. Wie oben schon erwähnt, ist für
die Erzeugung der Regelgleichspannung eine Gleichrichtung
des FM-Signals erforderlich, und bei den zur Rede stehenden sehr hohen Frequenzen lassen sich nur ganz spezielle
Gleichrichter - z.B. Schottky-Dioden - verwenden, die
in der Anschaffung relativ teuer sind. Außerdem besitzen diese Gleichrichter eine ausgeprägte Temperaturabhängigkeit, so daß man gezwungen ist, besondere Kompensationsschaltungen vorzusehen, um die Temperaturabhängigkeit der Gleichrichter zu kompensieren. Ferner
besitzen die Dioden bekanntlich einen niederohmigen
Eingang, da sie in ihrem Durchlaßbereich einen Strom
fließen lassen. Es ist somit notwendig, die dadurch bedingten Verlußte durch eine zusätzliche Verstärkung -
verbunden mit einem weiteren Schaltungsaufwand - auszugleichen.

Die soweit beschriebenen Maßnahmen sowie die dadurch
verursachten Kosten lassen sich zwar bei einem kommerziellen Gerät noch rechtfertigen, bei einer Fertigung
in Serienproduktion sind sie aber nicht mehr zu vertreten. Andererseits gewinnt aber mit der zunehmenden
Bedeutung des Satellitenfernsehens und mit ihrer möglichen Anwendung auch für Privathaushalte der Aufbau
kostengünstiger Schaltungen eine große Bedeutung.

Der Erfindung liegt daher die Aufgabe zugrunde, ein Verfahren zur Erzeugung einer vom Pegel eines hochfrequenten FM-Signals abhängigen Regelgleichspannung anzugeben, welches den Einsatz billiger Bauelemente ermöglicht und trotzdem mit hoher Empfindlichkeit arbeitet. Außerdem soll durch die Erfindung eine Schaltungsanordnung zur Durchführung des Verfahrens geschaffen werden.

Die Lösung der Aufgabe erfolgt bei dem im Oberbegriff
des Anspruchs 1 genannten Verfahren dadurch, daß das
hochfrequente FM-Signal mit einem niederfrequenten
Hilfssignal moduliert wird, und daß die Regelgleichspannung nach einer Demodulation des modulierten FM-
Signals durch Gleichrichtung des Hilfssignals mittels
eines Gleichrichters erzeugt wird.

Bei der Erfindung wird also der neue und überraschende
Verfahrensschritt gewählt, das bezüglich seines Pegels
automatisch einzustellende hochfrequente FM-Signal mit
einem Hilfssignal zu modulieren und nach anschließender
Demodulation die Regelgleichspannung durch Gleichrichtung des Hilfssignals zu erzeugen, während man bisher
den Weg beschritten hat, die Regelgleichspannung durch
Gleichrichtung des FM-Signals selbst zu gewinnen.

Auf den ersten Blick bedeutet die Maßnahme der Modulation des FM-Signals scheinbar einen Mehraufwand, da die Erfindung aber den Einsatz einfacher und billiger Bauelemente ermöglicht, wird bezüglich der Gesamtschaltung der durch die Modulation bedingte Aufwand mehr als ausgeglichen. Vielmehr schafft die Erfindung die Möglichkeit einer preiswerten Lösung, die hervorragend für die Serienproduktion geeignet ist.

Die erfindungsgemäße Schaltungsanordnung zur Durchführung des Verfahrens zeichnet sich durch einen von dem Rechteckgenerator gespeisten Modulator aus, dessen Hauptbestandteil ein üblicher Feldeffekttransistor ist. Ein wesentliches und vorteilhaftes Merkmal der erfindungsgemäßen Schaltungsanordnung besteht darin, daß der für die Demodulation benötigte Detektor durch einen im "Pinchoff"-Bereich betriebenen Feldeffekttransistor, vorzugsweise ein MES-FET, gebildet ist. Der Feldeffekttransistor wirkt wie ein Gleichrichter, der allerdings im Vergleich zu einer Diode extrem hochohmig ist und daher geringe Verluste aufweist.

Auch die weiteren Bestandteile der erfindungsgemäßen Schaltung benötigen lediglich einfache und preiswerte Bauteile. So genügen für den Rechteckgenerator sowie für den Komparator jeweils einfache Operationsverstärker.

Ferner ist es von Vorteil, daß der eigentliche Gleichrichter durch eine Billigdiode gebildet werden kann,
denn bei der Erfindung wird ja das Hilfssignal, welches
im niederfrequenten Bereich liegt und daher sozusagen
als NF-Signal angesehen werden kann, gleichgerichtet.
Demgegenüber erfolgte bei der eingangs erwähnten Lösung
eine Gleichrichtung des hochfrequenten FM-Signals, was
die Verwendung teurer Schottky-Dioden bedingt.

Weitere zweckmäßige Ausgestaltungen der Erfindung sind
in den Unteransprüche angegeben und der Zeichnung zu
entnehmen.

Nachfolgend wird die Erfindung anhand des in der Zeichnung dargestellten Ausführungsbeispiels näher erläutert.
Es zeigen:

Fig. 1    ein Prinzip-Blockschaltbild ei-
          ner Empfangsanordnung für Satel-
          litenfernsehen,

Fig. 2    ein Blockschaltbild zur Erzeugung
          einer Regelgleichspannung für eine automatische Verstärkungsregelung in einer Empfangsanordnung gemäß Fig. 1,

Fig. 3 - 6        jeweils eine graphische Darstellung von Signalen, und

Fig. 7        ein Ausführungsbeispiel einer
Schaltungsanordnung gemäß dem
Blockschaltbild in Fig. 2.

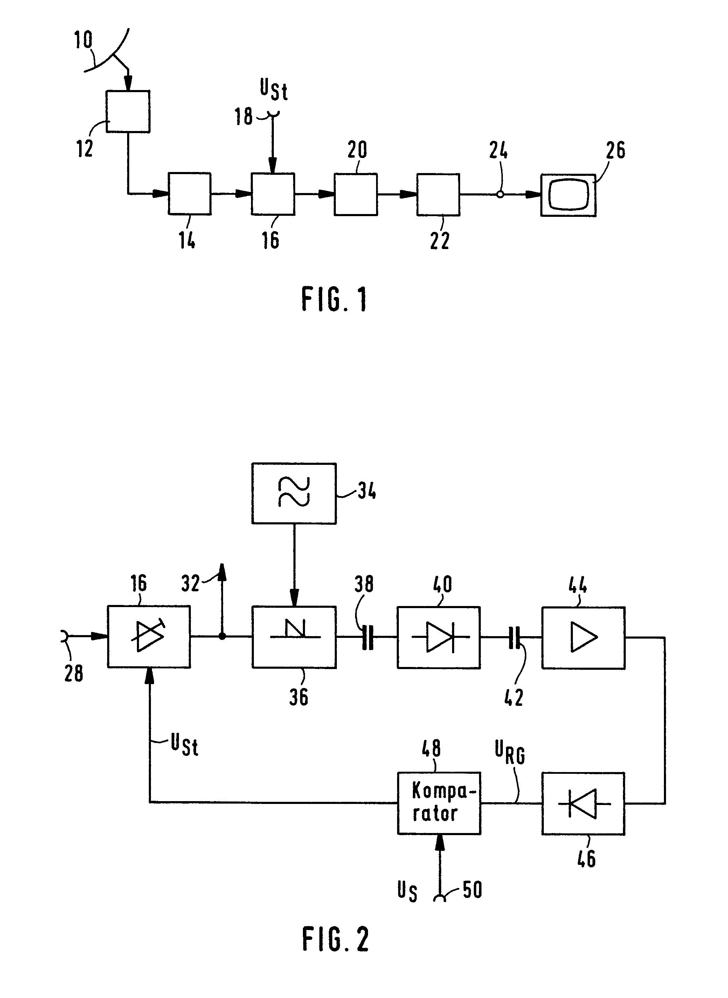

Zur Erläuterung eines bevorzugten Anwendungsgebietes der
Erfindung wird nachfolgend unter Bezugnahme auf Fig. 1
zunächst eine Empfangsanordnung für das Satellitenfernsehen im Prinzip erläutert. Die von einem nicht dargestellten Satelliten ausgesendeten und von einer Parabol-
Antenne 10 empfangenen Signale gelangen zu einem Umsetzer 12. Die Empfangsfrequenz liegt beispielsweise
bei 12 GHz, und mittels des Umsetzers 12 erfolgt eine
Transponierung in eine erste Zwischenfrequenz von 950 -
1750 MHz.

Auf den Umsetzer 12 folgt ein Kanalwähler 14 mit einer
weiteren Umsetzung der Frequenz in eine 2. Zwischenfrequenz von 480 MHz.

- 9 -

Über ein Stellglied 16, dessen Verstärkung in Abhängigkeit einer an dem Anschluß 18 vorhandenen Steuerspannung $U_{St}$ veränderbar ist, gelangen die Signale zu einem PLL-Demodulator 20, an den sich eine Video-Verarbeitungsschaltung 22 anschließt.

Mit der Bezugsziffer 24 ist eine Schnittstelle bezeichnet. Hier stehen Signale zur Verfügung, um entweder ein
direkt angeschlossenes Fernsehgerät 26 zu speisen, oder
um die Signale in ein nicht dargestelltes Kabelnetz
einzuspeisen, an welches eine Vielzahl von Fernsehgeräten angeschlossen werden kann.

Das erwähnte Stellglied 16 wirkt als veränderbarer Verstärker und erfüllt die Funktion, den HF-Pegel des FM-
Signals für den PLL-Demodulator automatisch einzustellen
und konstant zu halten, damit im linearen Bereich des
PLL-Demodulators gearbeitet werden kann.

Die den Verstärkungsgrad des Stellgliedes 16 bestimmende
Steuerspannung $U_{St}$ wird durch Vergleich einer Sollspannung $U_S$ mit einer Regelgleichspannung $U_{RG}$ gewonnen, und
anhand von Fig. 2 wird nachfolgend die Funktion einer
entsprechenden Verstärkerregelschaltung erläutert.

An dem Anschluß 28 des Stellgliedes 16 liegt das FM-
Signal mit der zweiten Zwischenfrequenz, und durch den
Pfeil 32 ist der weitere Signalweg zum PLL-Demodulator
20 (vgl. Fig. 1) angedeutet.

Über das Stellglied 16 gelangen die hochfrequenten FM-
Signale zu einem Modulator 36 (der gleichzeitig auch als
Verstärker wirkt), dem von einem Rechteckgenerator 34
Hilfssignale zugeführt werden, um die FM-Signale damit
zu modulieren.

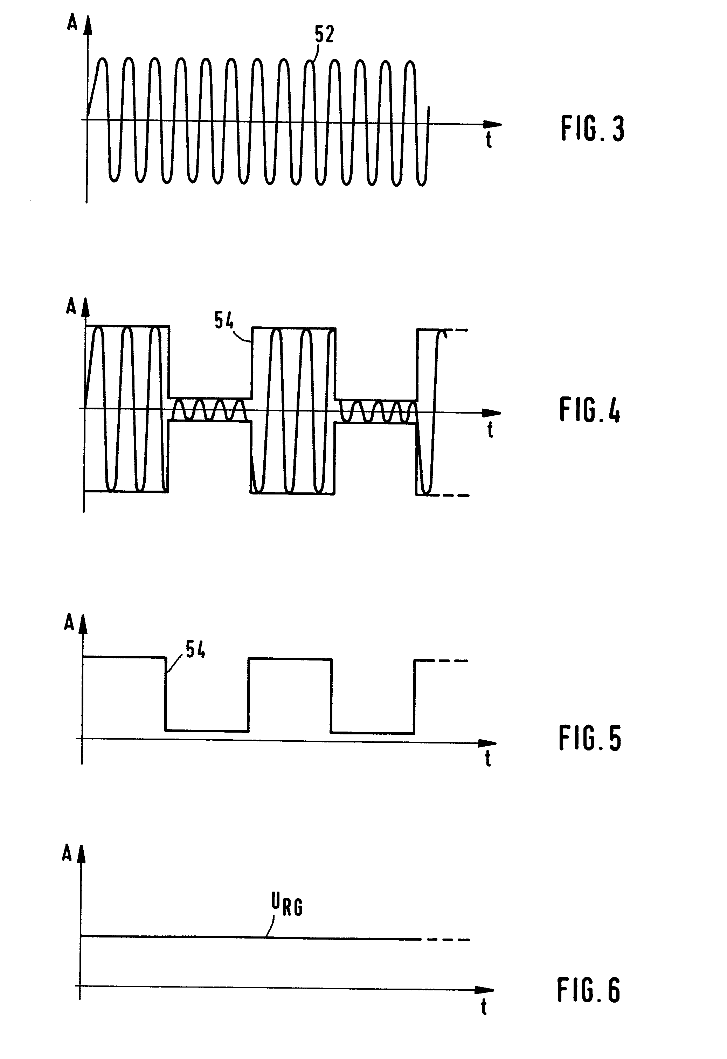

Zur Verdeutlichung ist das FM-Signal 52 in Fig. 3 längs
einer Zeitachse t aufgetragen, wobei die Amplitude bzw.
der Pegel mit A bezeichnet ist. In Fig. 4, welches die
Modulation darstellt, sowie in Fig. 5 sind die als Rechtecksignale 54 vorliegenden Hilfssignale zu erkennen.
Da diese zur Modulation des hochfrequenten FM-Signals
52 verwendet werden, kann man die Rechtecksignale 54
auch als niederfrequente Signale (NF) betrachten.

Über einen Koppelkondensator 38 gelangt das modulierte
Signal zu einem Detektor 40, welcher gemäß der Darstellung in Fig. 5 eine Demodulation durchführt, um das
Rechtecksignal 54 - also praktisch die NF - zu erhalten.

An den Detektor 40 schließt sich über einen weiteren Koppelkondensator 42 ein NF-Verstärker 44 an, dessen Ausgangssignale zu einem Gleichrichter 46 gelangen. Dieser braucht nur ein NF-Signal - nämlich das Rechtecksignal 54 gemäß Fig. 5 - gleichzurichten, so daß die Verwendung einer Billigdiode ausreichend ist.

Der Gleichrichter 46 erzeugt die in Fig. 6 dargestellte Regelgleichspannung $U_{RG}$, welche von dem Pegel A des FM-Signals 52 abhängt bzw. ein Maß für diesen Pegel ist, und die einem Komperator 48 zugeführt wird. An einem Anschluß 50 liegt eine Sollspannung $U_S$ für den gewünschten Pegelwert, und der Komperator 48 erzeugt durch Vergleich der Regelgleichspannung $U_{RG}$ mit der Sollspannung $U_S$ die Steuerspannung $U_{St}$ für die Ansteuerung des Stellgliedes 16. Je nach Größe der Steuerspannung $U_{St}$ wird die Verstärkung des Stellgliedes 16 so eingestellt, daß der Pegel des FM-Signals 52 automatisch konstant gehalten werden kann.

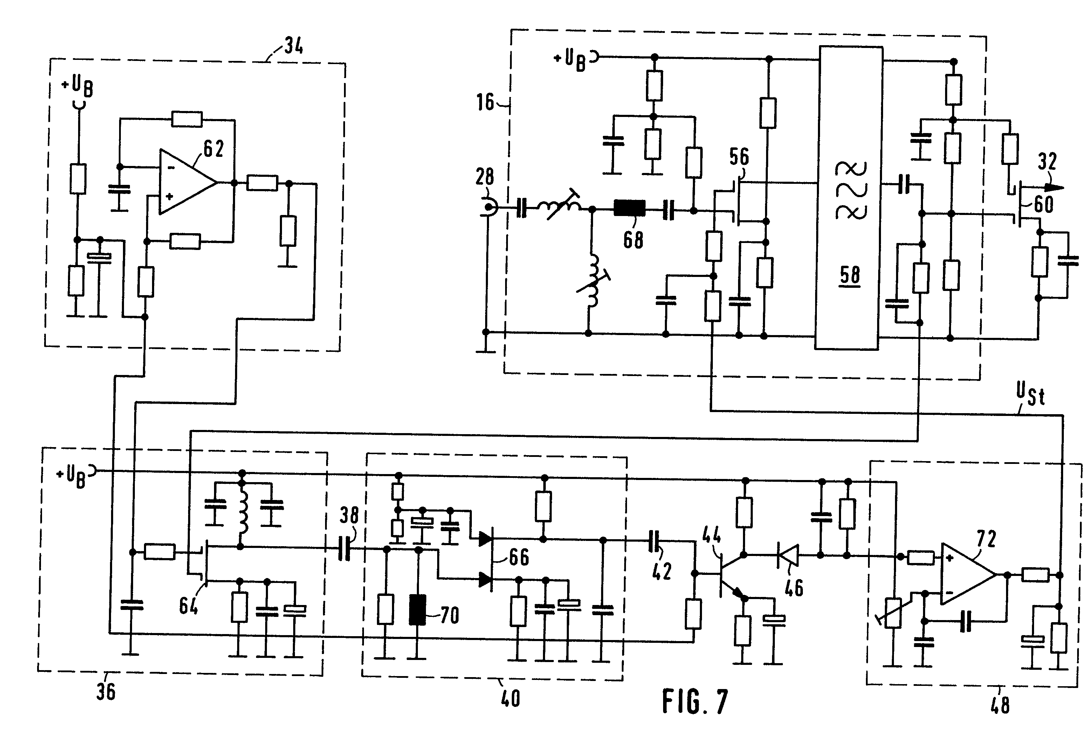

Fig. 7 zeigt ein detailliertes Schaltbild einer automatischen Verstärkerregelschaltung gemäß dem voranstehend erläuterten Blockschaltbild in Fig. 2, wobei gleiche Teile durch gleiche Bezugszeichen gekennzeichnet sind. Zum besseren Verständnis und zur Verdeutlichung der in dem Blockschaltbild in Fig. 2 gezeigten Elemente sind
diese in Fig. 7 durch gestrichelt gezeichnete Linien
hervorgehoben.

Über den Anschluß 28 gelangen die FM-Signale zum Stellglied 16, für dessen Aufbau die Verwendung eines einzigen Feldeffekttransistors 56 (MOS-FET) ausreichend
ist. Mit der Bezugsziffer 68 ist eine Streifenleitung
als Induktivität bezeichnet. Ferner besitzt das Stellglied 16, welches als ein in seiner Verstärkung veränderbarer Verstärker wirkt, noch ein als Bandpass
aufgebautes Filter 58. Über einen weiteren Feldeffekttransistor 60 (MOS-FET) gelangen die in ihrem Pegel
konstant gehaltenen FM-Signale zu den weiteren Schaltungsteilen in Fig. 1, wie durch den Pfeil 32 angedeutet
ist.

Der für die Erzeugung der Rechtecksignale vorgesehene
Rechteckgenerator 34 ist sehr einfach aufgebaut und umfaßt als wesentliches Bauteil einen Operationsverstärker
62. Die Rechtecksignale des Rechteckgenerators 34 werden
dem Modulator 36 zugeführt, welcher außerdem mit den FM-
Signalen gespeist wird und als aktives Modulationselement in vorteilhafter Weise lediglich einen Feldeffekttransistor 64 (MOS-FET) umfaßt. Neben der Modulation bewirkt diese Schaltung auch noch eine Verstärkung.

R 1824

Über den in Fig. 2 schon gezeigten Koppelkondensator 38 gelangt das modulierte Signal zu dem Detektor 40, welcher zur Gleichrichtung bzw. zur Demodulation einen Feldeffekttransistor 66 besitzt, der vorzugsweise ein MES-FET ist. An dieser Stelle kann aber auch ein üblicher MOS-FET verwendet werden. Mit der Bezugsziffer 70 ist innerhalb des Detektors 40 eine als Induktivität wirkende Streifenleitung bezeichnet.

Über den Koppelkondensator 42 (vgl. auch Fig. 2) wird das demodulierte NF-Signal einem als Verstärker 44 arbeitenden üblichen Transistor zugeführt, und durch die mit dem Kollektor des Transistors verbundene Diode 46, welche den NF-Gleichrichter bildet, wird das demodulierte Signal gleichgerichtet.

Die dadurch gewonnene Regelgleichspannung $U_{RG}$ gelangt zu dem Komparator 48, welcher einen Operationsverstärker 72 umfaßt und die Steuerspannung $U_{St}$ für das Stellglied 16 liefert.

Die soweit beschriebenen einzelnen Schaltungseinheiten werden von einer gemeinsamen Betriebsspannungsquelle $+U_B$ versorgt (z.B. 12 V). Die Darstellung in Fig. 7 verdeutlicht ohne weiteres, daß die einzelnen Schaltungseinheiten sich jeweils mit einfachen und billigen Bauelementen realisieren lassen. So kann beispielsweise
für die erforderliche Gleichrichtung eine Billigdiode
46 verwendet werden. Auch die Operationsverstärker sowie die Feldeffekttransistoren sind handelsübliche
und preiswerte Bauelemente. Damit läßt sich die erfindungsgemäße Schaltungsanordnung vorteilhaft in einer Serienproduktion herstellen. Gesonderte Temperaturkompensations-Schaltungen sind nicht erforderlich.

Neben der vorgesehenen Modulation des FM-Signals ist
die Verwendung des Feldeffekttransistors 66 für den
Detektor 40 ein wesentlicher Gesichtspunkt der Erfindung.
Der Feldeffekttransistor 66 wird im "Pinch-off"-Bereich
betrieben und bewirkt neben der angestrebten Gleichrichtung zusätzlich noch eine bedeutende Verstärkung
des Signals. Somit zeichnet sich die Erfindung nicht nur
durch die Möglichkeit der Verwendung billiger Bauelemente aus, zusätzlich besitzt die Schaltungsanordnung auch
noch eine besonders hohe Empfindlichkeit.

Patentansprüche
=================================

1.      Verfahren zur Erzeugung einer vom Pegel eines hochfrequenten FM-Signals abhängigen Regelgleichspannung für eine automatische Verstärkungsregelschaltung in einer Empfangsschaltung für Satellitenempfänger, insbesondere für Empfänger mit PLL-Demodulation beim Satellitenfernsehen, wobei ein Stellglied durch eine Steuerspannung beeinflußt wird, welche durch Vergleich einer Sollspannung mit der Regelgleichspannung gewonnen wird, dadurch gekennzeichnet, daß das hochfrequente FM-Signal (52) mit einem niederfrequenten Hilfssignal (54) moduliert wird, und daß die Regelgleichspannung ($U_{RG}$) nach einer Demodulation des modulierten FM-Signals durch Gleichrichtung des Hilfssignals mittels eines Gleichrichters (46) erzeugt wird.

- 2 -

2.      Verfahren nach Anspruch 1, dadurch gekennzeichnet, daß die Demodulation mit einem im "Pinch-
off"-Bereich betriebenen Feldeffekttransistor (66)
vorgenommen wird.


3.      Verfahren nach Anspruch 1 und/oder 2, dadurch
gekennzeichnet, daß das niederfrequente Hilfssignal
(54) in einem Rechteckgenerator (34) erzeugt wird.


4.      Schaltungsanordnung zur Durchführung des Verfahrens nach einem der vorhergehenden Ansprüche 1 - 3,
gekennzeichnet durch einen von dem Rechteckgenerator
(34) gespeisten Modulator (36), der einen ersten Feldeffekttransistor (64) umfaßt.


5.      Schaltungsanordnung nach Anspruch 4, dadurch
gekennzeichnet, daß dem Modulator (36) ein Detektor
(40) nachgeschaltet ist, der einen im "Pinch-off"-
Bereich betriebenen Feldeffekttransistor (66) umfaßt.


6.      Schaltungsanordnung nach Anspruch 5, dadurch
gekennzeichnet, daß der Detektor (40) mit einem Gleichrichter (46) verbunden ist, der die Regelgleichspannung
($U_{RG}$) für einen Komparator (48) liefert, und daß der
Komparator (48) mit dem Stellglied (16) verbunden ist.

7.     Schaltungsanordnung nach einem der vorhergehenden Ansprüche 4 - 6, dadurch gekennzeichnet, daß das Tastverhältnis der von dem Rechteckgenerator (34) erzeugten Rechtecksignale (54) 1:1 beträgt.

8.     Schaltungsanordnung nach Anspruch 5, dadurch gekennzeichnet, daß der im "Pinch-off"-Bereich betriebene Feldeffekttransistor (66) ein Gallium-Arsenit MES-FET ist.

0175058
R 1824

FIG. 1

FIG. 2

0175058

R 1824

FIG. 3

FIG. 4

FIG. 5

FIG. 6

FIG. 7